(19) Europäisches Patentamt
European Patent Office
Office européen des brevets

(11) **EP 0 449 404 B1**

(12) **EUROPEAN PATENT SPECIFICATION**

(45) Date of publication and mention
of the grant of the patent:
**03.12.1997 Bulletin 1997/49**

(51) Int Cl.6: **H01L 21/336**, H01L 21/84,
H01L 21/027

(21) Application number: **91300609.4**

(22) Date of filing: **28.01.1991**

(54) **Method of manufacturing a thin-film semiconductor device on a transparent insulative substrate**

Verfahren zur Herstellung eines Dünnschicht-Halbleiterbauteils auf einem transparenten, isolierenden Substrat

Méthode de fabrication d'un composant semi-conducteur à film mince sur un substrat isolant transparent

(84) Designated Contracting States:
**DE FR GB**

(30) Priority: **30.03.1990 JP 81356/90**

(43) Date of publication of application:
**02.10.1991 Bulletin 1991/40**

(73) Proprietor: **KABUSHIKI KAISHA TOSHIBA**
**Kawasaki-shi, Kanagawa-ken 210 (JP)**

(72) Inventor: **Uchikoga, Shuichi**
**c/o Intellectual Property Div.**
**Minato-ku, Tokyo 105 (JP)**

(74) Representative: **Freed, Arthur Woolf et al**
**MARKS & CLERK,**
**57-60 Lincoln's Inn Fields**
**London WC2A 3LS (GB)**

(56) References cited:
**EP-A- 0 228 316         EP-A- 0 270 323**
**EP-A- 0 338 766         GB-A- 2 212 661**

- **IEEE TRANSACTIONS ON ELECTRON DEVICES.**
  **vol. 36, no. 12, December 1989, NEW YORK US**
  **pages 2883 - 2888; Heinz H. BUSTA et al.:**
  **"Self-aligned bottom-gate**
  **submicrometer-channel-length a-Si:H Thin-Film**
  **Transistors"**

- **PROCEEDINGS OF THE SID. vol. 25, no. 1, 1984,**
  **LOS ANGELES US pages 21 - 24; S KAWAI et al.:**
  **"A self-alignment processed a-Si:H TFT matrix**
  **circuit for LCD panels"**
- **IEEE TRANSACTIONS ON ELECTRON DEVICES.**
  **vol. 36, no. 12, December 1989, NEW YORK US**
  **pages 2903 - 2907; BIING-SENG WU et al.:**
  **"Process-controlled staggered ambipolar**
  **amorphous-Silicon Thin-Film transistor"**
- **PATENT ABSTRACTS OF JAPAN vol. 11, no. 17**
  **(E-471)(2464) 17 January 1987, & JP-A-61 188968**
  **(SHARP CORP.) 22 August 1986,**
- **PATENT ABSTRACTS OF JAPAN vol. 11, no. 65**
  **(E-484)(2512) 27 February 1987, & JP-A-61**
  **224362 (FUJI XEROX CO. LTD.) 06 October 1986,**
- **PATENT ABSTRACTS OF JAPAN vol. 12, no. 254**
  **(E-634)(3101) 16 July 1988, & JP-A-63 041077**
  **(NIPPON SHEET GLASS CO. LTD.) 22 February**
  **1988,**

Remarks:
The file contains technical information submitted after the application was filed and not included in this specification

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

The present invention relates generally to a method of manufacturing a thin-film semiconductor device on a transparent insulative substrate, and more particularly to a method of manufacturing a thin-film semiconductor device by means of a reverse-side exposure process.

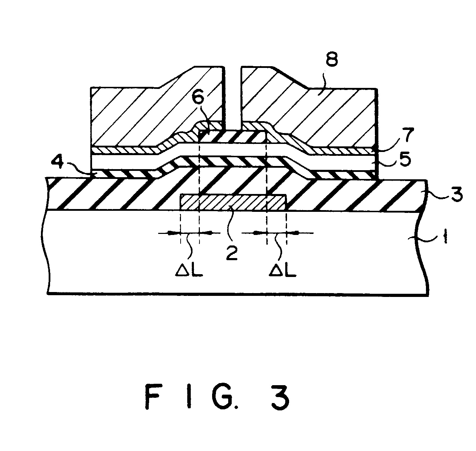

As a conventional thin-film semiconductor device, there is known a reverse stagger type thin-film transistor (TFT), as shown in Fig. 3.

The reverse stagger type TFT is manufactured in the following manner. A metal thin film is deposited on an insulative substrate 1. The metal thin film is patterned by means of photolithography with use of a photomask, thereby forming a gate electrode 2. Thereafter, insulative layers 3 and 4, a semiconductor active layer 5 and a channel protection layer 6 are deposited by means of plasma CVD. Subsequently, the channel protection layer 6 is patterned by means of lithography with use of a photomask. After a contact layer 7 is deposited, the active layer 5 for the TFT is formed in an island shape by means of lithography with use of a photomask. Then, in order to attain a contact with the gate electrode 2 of the TFT, the insulative layer 3 is patterned to form an aperture by means of lithography with use of a photomask. After the aperture is formed, a metal layer for forming a source/ drain electrode is deposited, and a source/drain electrode 8 is formed by means of lithography with use of a photomask.

As has been described above, in order to manufacture the TFT, at least five photomasks are required. In the example shown in Fig. 3, except the gate patterning, the patterning using photomasks must be performed while the patterns are aligned with each other. The alignment of the patterns directly determines the shape of the semiconductor device. If the patterns are not precisely aligned, desired characteristics are not obtained. In particular, in a liquid crystal display device using this type of TFT at a large area, non-uniformity in the shape and characteristics of the TFT results in a non-uniformity quality of images. Consequently, the productivity and yield is degraded.

Regarding the TFT shape shown in Fig. 3, the formation of the channel protection layer 6 is especially important. The reason is that the channel protection layer 6 serves not only as a protection layer but also as a pattern for determining the channel length and channel width of the TFT. When the pattern is formed with use of a photomask, the exact alignment between the pattern and the gate electrode 2 is very important in order to attain constant TFT characteristics. In this case, the pattern must be aligned with respect to vertical/horizontal components as well as rotational components. Therefore, the alignment precision is required strictly.

On the other hand, not only the shape and alignment of the channel protection layer 6 but also the overlapping of the source/drain and the gate electrode 2 is essential for ensuring reliability. In Fig. 3, the length of an overlapped region between the source/drain and the gate electrode 2 is AL. The region corresponding to AL is indispensable for ensuring stable contact between the contact layer 7 and the active layer 5. When a voltage is applied to the gate electrode 2, a carrier-accumulation layer is formed within the semiconductor active layer 5 and the TFT is turned on. Since the accumulation layer is formed in a region over which an electric field of the gate electrode 2 extends, the substantial junction between the active layer 5 and the contact layer 7 depends on the area of the region $\Delta L$. Thus, in the case of patterning, an erroneous alignment of the region AL greatly affects the characteristics of the TFT.

In other words, if the region $\Delta L$ is erroneously aligned, variation may occur in an ON-current of the TFT or carrier mobility, and an off-set TFT, with which adequate ON-current and carrier mobility cannot be obtained, may be manufactured. When the TFT is applied to a liquid crystal device, such drawbacks as non-uniform display, flickering, or luminance points may occur.

In the prior art, a photomask is manually aligned in an exposure apparatus, or mechanical auto-alignment is employed, as in a stepper exposure apparatus. When the photomask is manually aligned, as in the former case, the patterning precision varies depending on who operates the exposure apparatus. In the latter case, the alignment precision depends on mechanical operations, and the patterning precision is limited by the mechanical precision of the exposure apparatus. Under the situation, when a liquid crystal display device using a TFT is manufactured, it is very difficult to carry out patterning alignment over the entire area. In particular, in the prior art, it is difficult to manufacture large liquid crystal display devices with high reproducibility.

As has been stated above, in the conventional method of fabricating a thin-film semiconductor device, a number of photomasks are required, and it is very difficult to precisely align the patterns of the photomasks with high reproducibility. In particular, in the TFT, the erroneous alignment of the channel protection layers greatly affects the TFT characteristics.

The object of the present invention is to provide a method of manufacturing a thin-film semiconductor device, wherein the number of photomasks employed can be reduced and a channel protection layer of a TFT or the like can be precisely aligned with a gate electrode.

We acknowledge that EP-A-338 766 discloses the fabrication of a thin film transistor on a transparent insulative substrate by forming an opaque metal gate electrode on the substrate, followed by an insulative film, then an active layer, then a channel protection layer and then a positive first resist; photolithographically exposing the first resist from the reverse face of the substrate using the gate electrode as a mask and then patterning the active layer in the same way.

The invention provides a method as defined in Claim 1.

This invention can be more fully understood from the following detailed description of preferred embodiments, by way of example only, when taken in conjunction with the accompanying drawings, in which:

Figs. 1A to 1F are cross-sectional views for illustrating a method of manufacturing a TFT according to a first embodiment of the present invention;

Fig. 2 is a cross-section view showing an element structure, for explaining a method according to a second embodiment; and

Fig. 3 is a cross-sectional view showing the element structure of a conventional TFT.

Embodiments of the present invention will now be described in detail.

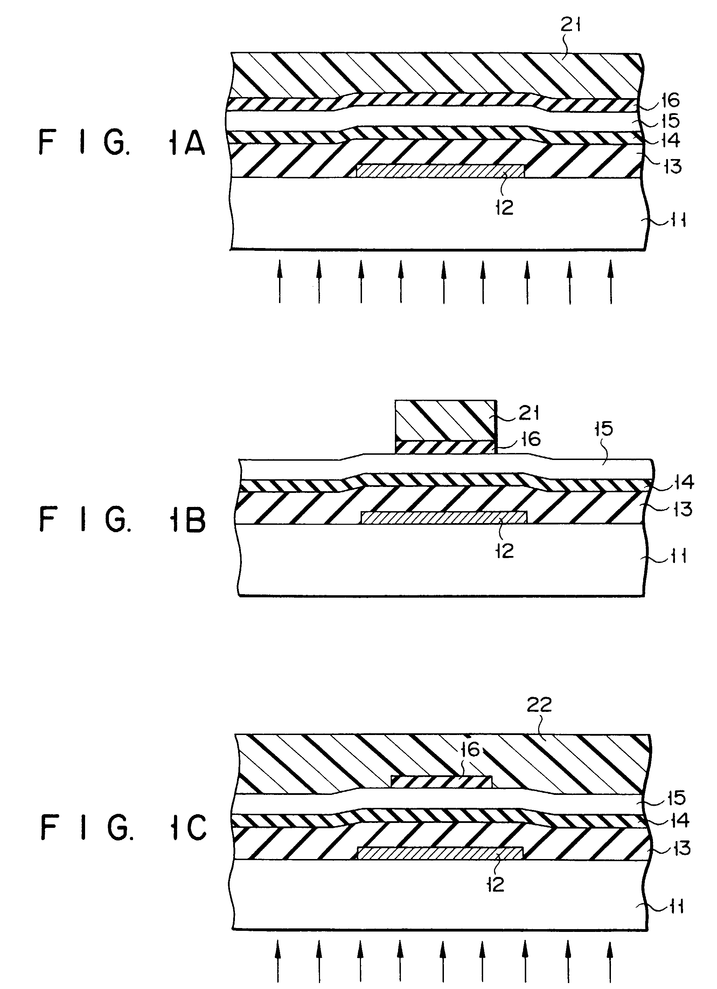

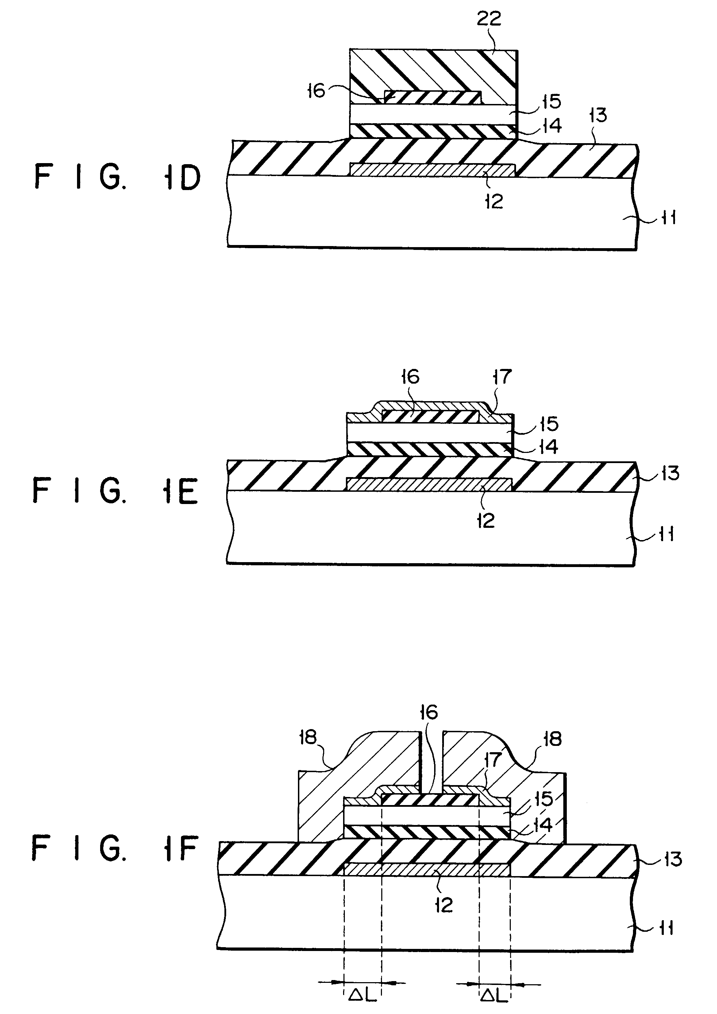

Figs. 1A to 1F are cross-sectional views for illustrating a method of manufacturing a TFT according to a first embodiment of the present invention.

As is illustrated in Fig. 1A, for example, Mo-Ta is deposited on a transparent insulative substrate 11 of, e. g. glass, by means of sputtering, thereby forming an opaque metal thin film on the substrate 11. The metal film is patterned by means of conventional lithography, thus forming a gate electrode 12. Subsequently, a lamination of, a silicon oxide film 13 and a silicon nitride film 14 is formed on the substrate 11 and the gate electrode 12 by means of plasma CVD. For example, an amorphous silicon film is deposited as an active layer 15 by means of plasma CVD. Subsequently, a silicon nitride film is deposited as a channel protection layer 16. Thereafter, a first photoresist 21 of a positive type is coated on the silicon nitride film deposited as the channel protection layer 16, and the reverse side of the substrate 11 is exposed. In the step of the reverse-side exposure, the amount of exposure light is made sufficiently greater than that necessary for patterning (i.e. the amount of exposure light necessary for forming a resist pattern which is the same as the pattern of the gate electrode 12).

In the exposure step, the gate electrode 12 serves as a mask, and the resist 21 is selectively exposed. The amount of exposure light is excessive, and therefore the width of the developed resist pattern is less than that of the gate electrode 12 used as the mask, as shown in Fig. 1B. Using the resist 21, the silicon nitride film serving as channel protection layer 16 is selectively etched, so as to leave a selected portion of the channel protection layer 16 above the gate electrode 12.

After the resist 21 is removed, a second photoresist 22 of a positive type is coated once again, as shown in Fig. 1C, and the reverse side of the substrate 11 is exposed once again. In this case, the amount of exposure light is less than that of exposure light used for forming the channel protection layer 16.

The resist 22 is developed after exposure, thereby forming a resist pattern, as shown in Fig. 1D. The resist pattern has a greater width than the channel protection layer 16. Subsequently, using the resist 22 as a mask, the semiconductor active layer 15 and silicon nitride film 14 are selectively etched. Thus, the semiconductor active layer 15 having a greater width than the channel protection layer 16 can be formed. In other words, the semiconductor active layer 15 and the channel protection layer 16 can be formed in a self-alignment manner in relation to the gate electrode 12. In addition, the length of the channel protection layer 16 in the channel direction can be made less than that of the semiconductor active layer 15. After this step, the resist 22 is removed.

After the channel protection layer 16 and the semiconductor active layer 15 are formed in the above manner, a contact layer 17 serving as a phosphor-doped amorphous silicon ($n^+$a-Si) film is deposited, as shown in Fig. 1E. Then, in order to prevent the formation of a parasitic TFT on the gate pattern, the amorphous silicon is patterned in an island shape with use of a photomask. In this case, unnecessary portions of the channel protection layer 16 are simultaneously etched. The etching in this case is carried out, for example, by a chemical dry etching (CDE) using a Freon gas. In this process, the precision of alignment between the photomask and other patterns may not be so strict, since the active layer region and the contact region with the active layer, which determine the TFT characteristics, have already been formed.

Subsequently, as in the conventional method, a source/drain electrode 18 of a lamination layer of chromium and aluminum is formed and a contact hole for attaining a contact with the gate electrode 12 is formed. Thus, the fabrication of the TFT is completed.

In this embodiment, reverse-side exposure is performed two times with different amounts of exposure light. Thus, the patterning of the channel protection layer 16 and the semiconductor active layer 15, which is conventionally very difficult, can be carried out in a self-alignment manner in relation to the gate electrode 12. Thus, the manufacturing process is simplified, with high reproducibility and high productivity. Since the width of the channel protection layer 16 is less than that of the semiconductor active layer 15, the junction between the semiconductor active layer 15 and the contact layer 17 is stabilized, and a highly reliable TFT can be fabricated.

Regarding the above embodiment, it should be noted that since the channel protection layer 16 can be formed within the gate electrode 12 in a self-alignment manner, a length $\Delta L$ of an overlapped portion of the source/drain region and the gate electrode 12 can be set with high precision, and the length $\Delta L$ on one side can easily be made equal to the length $\Delta L$ on the other side.

The value $\Delta L$ affects the characteristic of the TFT considerably. The value $\Delta L$ determines the parasitic capacitance between the gate and source formed in the TFT and the stability of contact between layers 15 and 17. If the value $\Delta L$ is increased, the stability of contact between layers 15 and 17 is enhanced but the parasitic capacitance is increased. On the other hand, if the value ΔL is decreased, the parasitic capacitance is decreased but the stability of contact between layers 15 and 17 is degraded.

Under the circumstances, it is necessary to find a point of compromise between the parasitic capacitance and the contact. In addition, it is necessary to overcome problems in the process, such as a decrease in adhesion of a resist and in thickness of the resist due to excessive reverse-side exposure. Taking these into account, it is desirable that the value ΔL in the TFT be:

$$0.3 \, \mu m \leq \Delta L \leq 3.0 \, \mu m$$

According to the above embodiment, this requirement was easily met by determining the amount of exposure light (over exposure) on the resist 21, without a need for alignment.

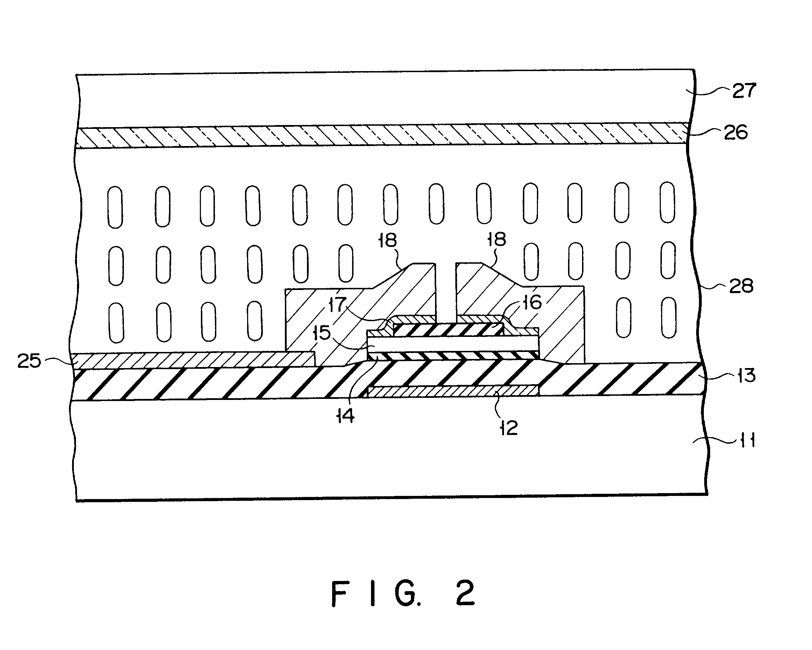

Fig. 2 is a view for describing a method according to a second embodiment of the present invention. In the second embodiment, the TFT according to the first embodiment is applied to an active matrix type liquid crystal display device.

In the process of manufacturing the TFT according to the first embodiment, after the amorphous silicon is patterned in an island shape, a transparent electrode 25, e.g. ITO (Indium Tin Oxide) is deposited on the silicon oxide film 13. The ITO is patterned in the shape of a display electrode, and thereafter a source/drain electrode 18 is formed. A liquid crystal material 28 is interposed between the TFT array substrate, thus manufactured, and a glass substrate 27 provided with a transparent electrode 26, thereby fabricating a liquid crystal display device.

Where a large liquid crystal display device is fabricated, erroneous patterning with use of a photomask results in a defective display screen. By virtue of the method of this embodiment, the number of photomasks employed can be reduced, and patterns, which have not easily been aligned in the prior art, can be formed easily. In addition, according to this embodiment, products can be manufactured with high reproducibility, without depending on the mechanical precision of a stepper, etc. Consequently, the productivity can be enhanced.

As has been described above, according to the present invention, when the thin film semiconductor device is manufactured, the gate electrode on the transparent insulating substrate is utilized, and the reverse side of the substrate is exposed to pattern the channel protection layer and the semiconductor active layer. Thus, the channel protection layer and the semiconductor active layer can be formed without positioning using photomasks. Therefore, the patterning can be performed precisely with high reproducibility. In other words, the main part of the thin film semiconductor device can be formed in a self-alignment manner in relation to the gate electrode. In addition, the width of the channel protection layer is made less than the channel width of the semiconductor active layer, thereby attaining reliable, high TFT characteristics.

In other words, since the channel protection layer and semiconductor active layer are patterned with the gate electrode used as a mask, the number of photomasks employed can be reduced, and the channel protection layer and the semiconductor active layer can be precisely aligned. Thus, the reliability and the characteristics of the thin film semiconductor device can be enhanced.

## Claims

1. A method of manufacturing a thin-film semiconductor device on a first major surface of a transparent insulative substrate (11) which also has a second major surface opposite to said first major surface, the method comprising the steps of:

   depositing an opaque metal film on the first major surface of the substrate (11) and patterning said opaque metal film so as to form a gate electrode (12);
   forming successively an insulating film (13,14), a semiconductor active layer (15) and a channel protection layer (16) on the first major surface of said substrate (11) and said gate electrode (12);
   patterning the channel protection layer (16) by means of photolithography with a first resist (21) exposed by means of reverse side overexposure using the gate electrode (12) as a mask; and
   patterning the semiconductor active layer (15) by means of photolithography with a second resist (22) exposed by means of reverse side exposure, with an amount of exposure light being less than that used during the step of patterning the channel protection layer (16) with the gate electrode (12) used as a mask, thereby making the width in the channel direction of the semiconductor active layer (15) greater than that of the channel protection layer (16);

   characterized in that said insulation film comprises a lamination of two films, of which one is a silicon oxide film (13) and the other is a silicon nitride film (14), formed on the major surface of said substrate (11) and said gate electrode (12).

2. A method according to claim 1, in which a distance ΔL between an end portion of the patterned semiconductor active layer (15) and an end portion of the patterned channel protection layer (16) is set to

$$0.3 \ \mu m < \Delta L < 3.0 \ \mu m.$$

3. A method according to claim 1, further comprising, in the step of patterning the channel protection layer, the steps of:

coating a positive-type first resist (21) on the channel protection layer (16);
radiating light on the second major surface of the substrate (11) and exposing the first resist (21) with the gate electrode (12) used as a mask, thereby leaving a patterned portion of the first resist (21) which is smaller than the gate electrode (12);
patterning the channel protection layer (16) with the first resist (21) used as a mask; and, in the step of patterning the semiconductor active layer (15), the steps of:
removing the first resist (21) and coating a positive-type second resist (22) on the semiconductor active layer (15) and the patterned channel protection layer (16);
radiating light on the second major surface of the substrate (11) and exposing the second resist (22) with the gate electrode (12) used as a mask, thereby leaving a patterned portion of the second resist (22), which is greater than the patterned portion of the first resist (21);
patterning the semiconductor active layer (15) with the second resist (22) used as a mask; and further comprising the step of:
removing the second resist (22) and forming a source/drain electrode (17) on the patterned semiconductor active layer (15).

4. A method according to claim 3, in which a distance $\Delta L$ between an end portion of the patterned portion of the first resist (21) and an end portion of the patterned portion of the second resist (22) is set to

$$0.3 \ \mu m \leq \Delta L \leq 3.0 \ \mu m.$$

5. A method according to claim 3 or 4, in which said first resist (21) is exposed by means of over-exposure, with the amount of exposure light greater than that necessary for forming a resist pattern equal in size to the gate electrode pattern.

**Patentansprüche**

1. Verfahren zur Herstellung eines Dünnschicht-Halbleiterbauteils auf einer ersten Hauptfläche eines durchsichtigen isolierenden Substrats (11), welches auch eine der ersten Hauptfläche gegenüberliegende zweite Hauptfläche aufweist, in folgenden Stufen:

Ablagern eines opaken Metallfilms auf der ersten Hauptfläche des Substrats (11) und Mustergebung des opaken Metallfilms zur Bildung einer Gateelektrode (12);

sukzessives Ausbilden eines isolierenden Films (13, 14), einer aktiven Halbleiterschicht (15) und einer Kanalschutzschicht (16) auf der ersten Hauptfläche des Substrats (11) und der Gateelektrode (12);

Mustergebung der Kanalschutzschicht (16) auf photolitographischem Wege mit einem durch rückseitige Überbelichtung unter Verwendung der Gateelektrode (12) als Maske belichteten ersten Resist (21), und

Mustergebung der aktiven Halbleiterschicht (15) auf photolitographischem Wege mit einem durch rückseitige Belichtung belichteten zweiten Resist (22), wobei die Belichtungsmenge geringer ist als bei der Bemusterung der Kanalschutzschicht (16) unter Verwendung der Gateelektrode (12) als Maske, um die Breite der aktiven Halbleiterschicht (15) in der Kanalrichtung gegenüber derjenigen der Kanalschutzschicht (16) zu vergrößern,

dadurch gekennzeichnet, daß der Isolierfilm ein Laminat aus zwei auf der Hauptfläche des Substrats (11) und der Gateelektrode (12) gebildeten Filmen, von denen der eine aus einem Siliciumoxidfilm (13) und der andere aus einem Siliciumnitridfilm (14) besteht, umfaßt.

2. Verfahren nach Anspruch 1, wobei der Abstand AL zwischen einem Endteil der gemusterten aktiven Halbleiterschicht (15) und einem Endteil der gemusterten Kanalschutzschicht (16) auf 0,3 µm < ΔL < 3,0 µm eingestellt ist.

3. Verfahren nach Anspruch 1, bei welchem zusätzlich bei der Mustergebung der Kanalschutzschicht folgende Stufen:

Auftragen eines positiven ersten Resists (21) auf die Kanalschutzschicht (16);

Aufstrahlen von Licht auf die zweite Hauptfläche des Substrats (11) und Belichten des ersten Resists (21) unter Verwendung der Gateelektrode (12) als Maske, um einen gemusterten Teil des ersten Resists (21), der kleiner ist als die Gateelektrode (12), zurückzulassen;

Mustergebung der Kanalschutzschicht (16) unter Verwendung des ersten Resists (21) als Maske;

und bei der Mustergebung der aktiven Halbleiterschicht (15) folgende Stufen:

Entfernen des ersten Resists (21) und Auftragen eines positiven zweiten Resists (22) auf die aktive Halbleiterschicht (15) und die gemusterte Kanalschutzschicht (16);

Aufstrahlen von Licht auf die zweite Hauptfläche des Substrats (11) und Belichten des zweiten Resists (22) unter Verwendung der Gateelektrode (12) als Maske, um einen gemusterten Teil des zweiten Resists (22), der größer ist als der gemusterte Teil des ersten Resists (21) zurückzulassen;

Mustergebung der aktiven Halbleiterschicht (15) unter Verwendung des zweiten Resists (22) als Maske,

und zusätzlich der zweite Resist (22) entfernt und auf der gemusterten aktiven Halbleiterschicht (15) eine Source/Drain-Elektrode (17) gebildet werden

durchgeführt werden.

4. Verfahren nach Anspruch 3, wobei der Abstand AL zwischen einem Endteil des gemusterten Bereichs des ersten Resists (21) und einem Endteil des gemusterten Bereichs des zweiten Resists (22) auf 0,3 μm ≤ ΔL ≤ 3,0 μm eingestellt wird.

5. Verfahren nach Anspruch 3 oder 4, wobei der erste Resist (21) durch Überbelichtung mit einer größeren Belichtungsmenge, als zur Bildung eines Resistmusters einer zum Gateelektrodenmuster gleichen Größe erforderlich ist, belichtet wird.

**Revendications**

1. Procédé de fabrication d'un dispositif à semiconducteur à film mince sur une première surface principale d'un substrat isolant transparent (11) qui comporte également une seconde surface principale opposée à ladite première surface principale, le procédé comprenant les étapes de :

dépôt d'un film métallique opaque sur la première surface principale du substrat (11) et conformation dudit film métallique opaque de manière à former une électrode de grille (12); formation successivement d'un film isolant (13, 14), d'une couche active semiconductrice (15) et d'une couche de protection de canal (16) sur la première surface principale dudit substrat (11) et sur ladite électrode de grille (12); conformation de la couche de protection de canal (16) au moyen d'une photolithographie qui utilise une première réserve (21) qui est exposée au moyen d'une sur-exposition par face arrière en utilisant l'électrode de grille (12) en tant que masque ; et conformation de la couche active semiconductrice (15) au moyen d'une photolithographie qui utilise une seconde réserve (22) qui est exposée au moyen d'une exposition par face arrière, la quantité de lumière d'exposition étant inférieure à celle utilisée pendant l'étape de conformation de la couche de protection de canal (16) à l'aide de l'électrode de grille (12) qui est utilisée en tant que masque pour ainsi rendre la largeur suivant la direction de canal de la couche active semiconductrice (15) supérieure à celle de la couche de protection de canal (16),

caractérisé en ce que ledit film isolant comprend un empilement de deux films, dont l'un est un film en oxyde de silicium (13) et dont l'autre est un film en nitrure de silicium (14), formé sur la surface principale dudit substrat (11) et sur ladite électrode de grille (12).

2. Procédé selon la revendication 1, dans lequel une distance ΔL entre une partie d'extrémité de la couche active semiconductrice conformée (15) et une partie d'extrémité de la couche de protection de canal conformée (16) est établie à :

$$0,3 \ \mu m < \Delta L < 3,0 \ \mu m.$$

3. Procédé selon la revendication 1, comprenant en outre, lors de l'étape de conformation de la couche de protection de canal, les étapes de :

dépôt d'une première réserve du type positif (21) sur la couche de protection de canal (16); rayonnement d'une lumière sur la seconde surface principale du substrat (11) et exposition de la première réserve (21) à l'aide de l'électrode de grille (12) qui est utilisée en tant que masque pour ainsi laisser une partie conformée de la première réserve (21) qui est plus petite que l'électrode de grille (12); conformation de la couche de protection de canal (16) à l'aide de la première réserve (21) qui est utilisée en tant que masque, et lors de l'étape de conformation de la couche active semiconductrice (15), les étapes de : enlèvement de la première réserve (21) et dépôt d'une seconde réserve du type positif (22) sur la couche active semiconductrice (15) et sur la couche de protection de canal conformée (16) ;

rayonnement d'une lumière sur la seconde surface principale du substrat (11) et exposition de la seconde réserve (22) à l'aide de l'électrode de grille (12) qui est utilisée en tant que masque pour ainsi laisser une partie conformée de la seconde réserve (22) qui est plus grande que la partie conformée de la première réserve (21) ;

conformation de la couche active semiconductrice (15) à l'aide de la seconde réserve (22) qui est utilisée en tant que masque, et comprenant en outre l'étape de :

enlèvement de la seconde réserve (22) et formation d'une électrode de source/drain (17) sur la couche active semiconductrice conformée (15).

4. Procédé selon la revendication 3, dans lequel une distance ΔL entre une partie d'extrémité de la partie conformée de la première réserve (21) et une partie d'extrémité de la partie conformée de la seconde réserve (22) est établie à :

$$0,3 \ \mu m \leq \Delta L \leq 3,0 \ \mu m.$$

5. Procédé selon la revendication 3 ou 4, dans lequel ladite première réserve (21) est exposée au moyen d'une sur-exposition, la quantité de lumière d'exposition étant supérieure à celle nécessaire pour former un motif de réserve d'une taille égale à celle du motif d'électrode de grille.

FIG. 1A

FIG. 1B

FIG. 1C

FIG. 1D

FIG. 1E

FIG. 1F

F I G. 2

EP 0 449 404 B1

# F I G. 3